# DEMANDE DE BREVET EUROPEEN

(11) **EP 1 760 772 A1**
(43) Date de publication de la demande: **07.03.2007**
(21) Numéro de dépôt: 06291365.2
(22) Date de dépôt: 28.08.2006
(51) Int. Cl.: H01L 21/60, H01L 21/768

(54) **Procédé de protection de la grille d'un transistor et circuit intégré correspondant**

(30) Priorité: 29.08.2005 FR 0508835
(71) Demandeur: STMicroelectronics ( Crolles 2) SAS, 38920 Crolles (FR)
(72) Inventeur: Ferreira, Paul, 38530 Barraux (FR)
(74) Mandataire: Casalonga, Axel

(57) **Abrégé**

Procédé de protection de la grille (6) d'un transistor dans un circuit intégré (1) pour la réalisation d'un plot d'interconnexion, le transistor comprenant un substrat (2), au moins une zone active formée dans le substrat, au moins une zone isolante (3) formée dans le substrat, une grille (6), la grille étant formée au-dessus d'une zone active, le procédé comprenant les étapes suivantes :
- former une couche diélectrique (16) sur le transistor, la couche diélectrique venant recouvrir la grille ;
- effectuer une gravure de la couche diélectrique (16) en la laissant subsister au moins sur ladite grille de telle sorte que ladite grille est isolée électriquement par rapport à d'autres éléments formés au-dessus de ladite couche diélectrique, ladite gravure étant effectuée au moyen d'un masque utilisé pour la fabrication de la grille et au moyen d'un masque utilisé pour la fabrication de la zone isolante

## Description

L'invention concerne le domaine des circuits intégrés pourvus d'une architecture d'interconnexion extrêmement dense permettant un gain de densité à l'échelle de la cellule élémentaire d'un circuit intégré, par exemple une cellule mémoire de type DRAM ou SRAM.

Le document FR 2 821 208 (STMicroelectronics SA) décrit un procédé de protection de la grille d'un transistor dans un circuit intégré ayant pour but de réaliser un plot de connexion à cheval sur une grille de transistor et le substrat de silicium tout en étant isolé par rapport à la grille par une couche de nitrure gravée sélectivement hors de la zone de grille pour que le plot de connexion soit en contact avec le substrat. La gravure sélective est obtenue au moyen d'une couche de polysilicium dopé qui est ensuite partiellement gravée puis isolée par un bouchon en nitrure.

Le procédé est relativement complexe et onéreux à mettre en oeuvre. En outre, la demanderesse s'est aperçue que les espèces dopantes implantées dans le chapeau en polysilicium présentaient un risque de diffusion non négligeable vers d'autres couches.

L'invention vise à remédier aux inconvénients évoqués ci-dessus.

L'invention a notamment pour but de simplifier et de rendre plus économique la fabrication d'un circuit intégré à très haute densité.

Le procédé est destiné à la protection de la grille d'un transistor dans un circuit intégré pour la réalisation d'un plot d'interconnexion. Le transistor comprend un substrat, au moins une zone active formée dans le substrat, au moins une zone isolante formée dans le substrat, et une grille formée au-dessus d'une zone active.

Le procédé comprend les étapes suivantes :
- former une couche diélectrique sur le transistor, la couche diélectrique venant recouvrir la partie supérieure de la grille,
- retirer la couche diélectrique en la laissant subsister au moins sur ladite grille de telle sorte que ladite grille est isolée électriquement par rapport à d'autres éléments formés au-dessus de ladite couche diélectrique, ladite gravure étant effectuée au moyen d'un masque utilisé pour la fabrication de la grille et au moyen d'un masque utilisé pour la fabrication de la zone isolante.

La couche diélectrique est formée par des moyens économiques déjà mis en oeuvre pour la fabrication du transistor. La grille peut comprendre une partie inférieure et une partie supérieure comprenant du siliciure métallique.

Dans un mode de réalisation, le masque utilisé pour la fabrication de la grille et le masque utilisé pour la fabrication de la zone isolante sont combinés préalablement à la gravure. Une étape d'exposition suffit pour définir les parties à graver.

Dans un autre mode de réalisation, le masque utilisé pour la fabrication de la grille et le masque utilisé pour la fabrication de la zone isolante sont mis en oeuvre successivement. On peut ainsi exposer de façon plus faible une partie correspondant à une grille formée sur une zone active pour élargir la couche diélectrique.

Dans un mode de réalisation, la couche diélectrique comprend deux sous-couches superposées. La couche diélectrique peut comprendre une sous-couche à base d'oxyde d'aluminium et une sous-couche à base de nitrure de silicium.

Dans un autre mode de réalisation, la couche diélectrique comprend une couche à base d'oxyde d'aluminium.

La couche à base d'oxyde d'aluminium peut être formée par dépôt atomique. La couche à base d'oxyde d'aluminium peut être gravée sélectivement par rapport au substrat et la couche à base de nitrure de silicium peut être gravée sélectivement par rapport à la couche à base d'oxyde d'aluminium. La couche à base de nitrure de silicium peut servir d'arrêt lors de la gravure d'une couche de SiO2 formée à un niveau supérieur. La gravure de la couche à base d'oxyde d'aluminium peut être effectuée par voie humide avec du HF dilué. La gravure de la couche à base de nitrure de silicium peut être effectuée par voie sèche.

Dans un mode de réalisation, un plot d'interconnexion est formé au-dessus d'une zone active et partiellement au-dessus de la grille. Le plot d'interconnexion reste isolé de la grille par la couche diélectrique.

Dans un mode de réalisation, la formation de la couche diélectrique comprend le dépôt conforme d'au moins une couche pouvant être gravée sélectivement par rapport au substrat. Ladite couche peut ainsi être retirée du dessus du substrat.

Dans un mode de réalisation, le retrait partiel de la couche diélectrique comprend le dépôt d'une couche de résine, l'exposition de la couche de résine hors de ladite grille, le développement des parties exposées de la couche de résine, le retrait de la partie découverte de la couche diélectrique, et le retrait du reste de la couche de résine. Avant le dépôt d'une couche de résine a lieu le dépôt d'une couche de remplissage, et entre le développement des parties exposées de la couche de résine et le retrait de la partie découverte de la couche diélectrique, a lieu le retrait de la partie découverte de la couche de remplissage.

La couche de remplissage peut comprendre du carbone amorphe, notamment lorsque la couche diélectrique comprend une seule couche d'oxyde d'aluminium. La couche de remplissage peut comprendre un matériau de type antiréfléchissant connu sous le nom de « BARC ».

Le circuit intégré comprend un transistor formé dans un substrat pourvu d'au moins une zone isolante. Le transistor comprend au moins une zone active formée dans le substrat, une grille au-dessus d'une zone active, et une couche diélectrique comprenant de l'oxyde d'aluminium, recouvrant au moins la partie supérieure de la grille, de telle sorte que ladite grille est isolée électriquement par rapport à d'autres éléments formés au-dessus de ladite couche diélectrique.

On bénéficie d'une excellente sélectivité de gravure de la couche diélectrique par rapport au substrat, ce qui facilite l'utilisation de masques préexistants.

La grille peut comprendre une partie inférieure et une partie supérieure comprenant du siliciure métallique, par exemple du CoSi₂. Le siliciure métallique est à distance de la couche de nitrure de silicium.

Dans un mode de réalisation, la couche diélectrique comprend une épaisseur à base d'oxyde d'aluminium comprise entre 3 et 20 nm, préférablement entre 3 et 15 nm.

Dans un mode de réalisation, la couche diélectrique comprend, en outre, une épaisseur à base de nitrure de silicium comprise entre 5 et 15 nm, préférablement entre 8 et 12 nm. Lorsque la couche à base de nitrure de silicium est présente, la couche à base d'oxyde d'aluminium peut présenter une épaisseur inférieure ou égale à 6 nm, préférablement inférieure ou égale à 5 nm.

Grâce à l'invention, on bénéficie d'un procédé simple et robuste pour fabriquer des circuits intégrés possédant des contacts susceptibles d'être disposés au-dessus de zones de grille en polysilicium siliciuré tout en étant isolés électriquement. On peut ainsi créer des plots de contact à cheval entre la grille et une zone active de substrat, par exemple un drain ou une source, dont une zone supérieure peut également être siliciurée. La grille peut s'étendre longitudinalement jusqu'au-dessus d'une zone de tranchée d'isolation où la place nécessaire pour former un contact rejoignant des niveaux d'interconnexion est plus élevée. On peut ainsi diminuer l'espace entre un plot de contact et une grille en polysilicium à une distance de l'ordre de 30 à 40 nm, préférablement 30 à 35 nm, et ce avec un plot de contact présentant un diamètre de l'ordre de 60 à 90 nm avec une distance entre grilles de l'ordre de 80 nm tout en autorisant la siliciuration de zones supérieures des grilles en polysilicium. Le procédé peut être mis en oeuvre au moyen de masques de gravure utilisés pour des étapes antérieures de fabrication du circuit intégré, notamment des étapes de définition des tranchées d'isolation peu profondes et de définition des grilles, en général en polysilicium.

La présente invention sera mieux comprise à l'étude de la description détaillée de quelques modes de réalisation pris à titre d'exemples nullement limitatifs et illustrés par les dessins annexés, sur lesquels :
- la figure 1 est une vue schématique en coupe d'un circuit intégré en cours de fabrication ;
- les figures 2 à 8 sont des vues correspondantes à la figure 1 illustrant les étapes de fabrication selon un premier mode de réalisation de l'invention ; et
- les figures 9 à 14 sont des vues correspondantes à la figure 1 illustrant les étapes de fabrication selon un second mode de réalisation.

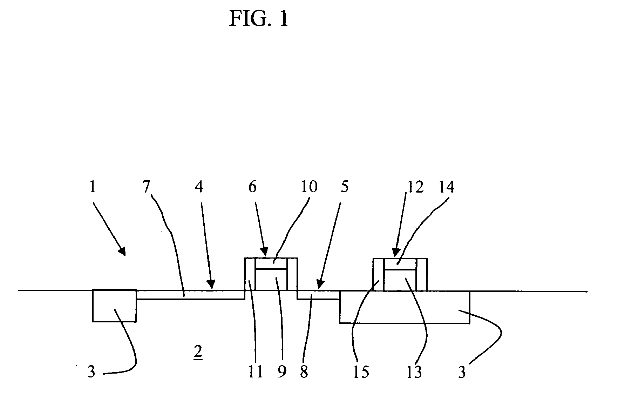

Comme on peut le voir sur la figure 1, le circuit intégré référencé 1 dans son ensemble comprend un substrat 2, par exemple en silicium, en silicium sur isolant généralement nommé SOI ou encore en silicium sur rien, généralement dénommé SON. Dans le substrat 2 sont formées une pluralité de tranchées d'isolation peu profondes 3 généralement dénommées STI, et comprenant un matériau isolant, par exemple du SiO₂. Le circuit intégré 1 comprend un transistor pourvu de zones de drain 4, de source 5 et d'une grille 6. Les zones de drain 4 et source 5 n'ont pas été représentées en détail et comprennent une partie supérieure siliciurée 7 et 8 respectivement, par exemple à base de CoSi₂, assurant un excellent contact électrique avec des plots de connexion. La grille 6 comprend une partie inférieure 9 à base de polysilicium, et une partie supérieure 10 siliciurée, par exemple à base de CoSi₂. Des espaceurs 11 sont disposés d'un côté et de l'autre des parties inférieure 9 et supérieure 10. Les espaceurs 11 peuvent comprendre du SiN ou du SiON.

Le circuit intégré 1 comprend également une autre grille 12 de structure semblable à la grille 6, mais disposée au-dessus d'une tranchée d'isolation 3 et non au-dessus d'une zone active. La grille 12 comprend une partie inférieure 13, une partie supérieure 14 et des espaceurs 15. La grille 12 peut se prolonger au-delà de la tranchée peu profonde 3 et venir coopérer avec des zones de drain et de source pour former un autre transistor non représenté. Le fait qu'une grille 12 se prolonge au-dessus d'une tranchée d'isolation 3 permet de venir former une interconnexion en contact avec la partie supérieure 14 de la grille 12 dans une zone du circuit intégré où la densité de composants est plus faible que dans les zones actives disposées entre deux tranchées d'isolation 3.

Ensuite, une couche diélectrique 16 est déposée sur l'ensemble du circuit intégré 1 et présente une épaisseur sensiblement constante et relativement faible, par exemple de l'ordre de 30 à 50 angströms. La couche diélectrique 16 peut comprendre de l'oxyde d'aluminium Al₂O₃. L'oxyde d'aluminium peut être déposé par un procédé de dépôt atomique de couche souvent désigné par l'acronyme anglais ALD. La couche diélectrique 16 recouvre le substrat 2, les tranchées d'isolation 3, les parties siliciurées 7, 8 et les grilles 6 et 12. La couche diélectrique 16 peut être gravée sélectivement par rapport aux tranchées d'isolation. L'oxyde d'aluminium présente une bonne sélectivité de gravure par rapport au SiO₂ souvent utilisé dans les tranchées d'isolation de type STI.

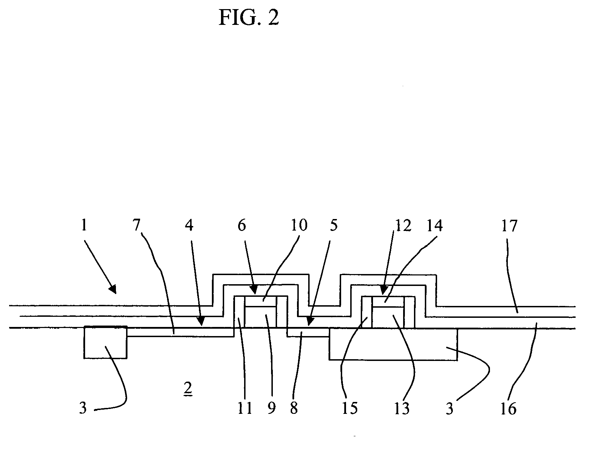

Ensuite, une couche diélectrique supplémentaire 17 est déposée sur la couche 16 de façon conforme. La couche diélectrique 17 présente une épaisseur relativement faible, de l'ordre de 50 à 200 angströms, préférablement entre 80 et 120 angströms. La couche diélectrique 17 peut comprendre du nitrure de silicium. La couche diélectrique 17 présente une excellente sélectivité de gravure par rapport à la couche diélectrique 16. Le nitrure de silicium peut être gravé par gravure sèche s'arrêtant sur l'oxyde d'aluminium. L'oxyde d'aluminium peut être gravé par voie humide avec de l'acide fluorhydrique dilué en s'arrêtant sur le dioxyde de silicium, sur le silicium du substrat ou encore sur les zones siliciurées 7 et 8. Le circuit intégré 1 se trouve dans l'état illustré sur la figure 2.

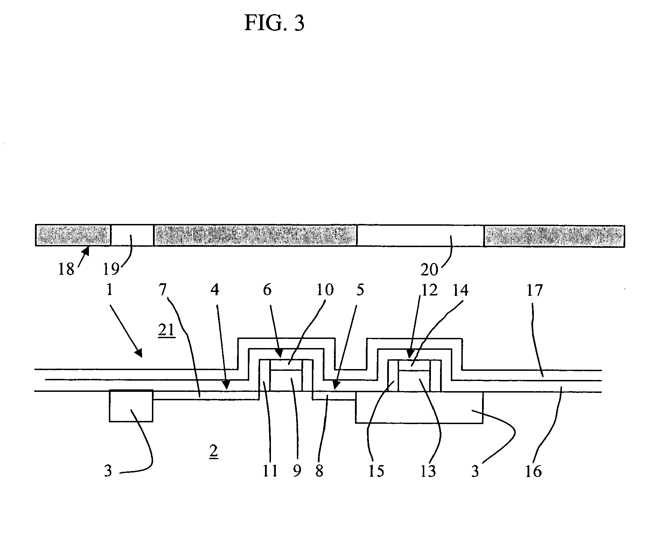

Comme illustré sur la figure 3, une couche de remplissage 21 est déposée sur la couche diélectrique 17, en général sur l'ensemble du circuit intégré 1. La couche de remplissage 21 présente une forte épaisseur et a pour but d'offrir une surface supérieure plane permettant les étapes de gravure par masque. La couche de remplissage 21 peut être à base de carbone amorphe déposé par un procédé chimique en phase vapeur également connu sous l'acronyme CVD. Le carbone amorphe peut faire l'objet d'une gravure sèche anisotropique. La couche de remplissage 21 peut également comprendre du BARC, acronyme anglais pour « Bottom Anti-Reflective coating ». Il s'agit d'une couche organique (carbonée), anti-réflective à la longueur d'onde utilisée par l'étape de lithographie planarisante, de 800 Å environ d'épaisseur, qui est ensuite enlevée par gravure sèche anisotropique à base d'O₂.

La surface supérieure de la couche de remplissage 21 est sensiblement plane et une couche de résine 18 y est déposée. On procède ensuite au moyen d'un masque approprié à l'exposition de zones 19 et 20 de la couche 18 de résine. Ledit masque peut être le masque ayant servi à la formation des tranchées d'isolation 3. Les zones exposées 19 et 20 sont disposées au-dessus des tranchées d'isolation.

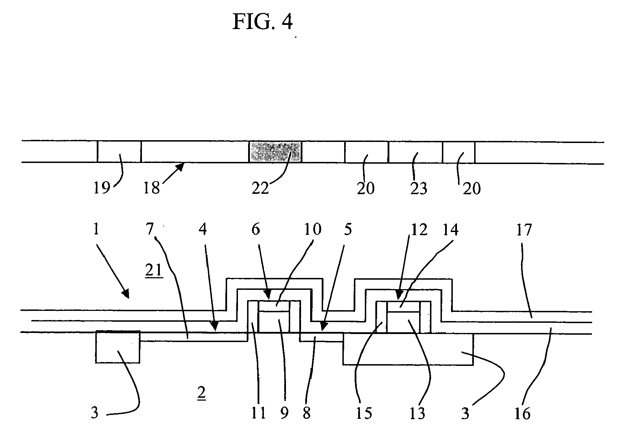

Puis, au moyen d'un autre masque ayant par exemple servi à la formation des grilles 6 et 12, on vient exposer l'ensemble de la couche de résine 18 à l'exception de deux zones protégées 22 et 23 situées verticalement au-dessus des grilles 6 et 12 (voir figure 4). La zone protégée 23 étant entièrement comprise dans la zone exposée 20, la résine se trouvant dans la zone protégée 23 a néanmoins déjà subi une exposition au préalable. Au contraire, la zone protégée 22 n'est exposée ni au cours de la première exposition dans la mesure où ladite zone protégée 22 est décalée par rapport aux tranchées d'isolation 3, ni au cours de la deuxième exposition où elle est spécifiquement protégée. Avantageusement, la deuxième exposition est plus faible que la première, de telle sorte que la résine se trouvant sur les bords de la zone protégée 22 subsiste sur une largeur supérieure à celle prévue sur le masque égale à celle de la grille 6. L'on parvient ainsi à conserver une zone protégée 22 dont la largeur correspond sensiblement à celle de la grille 6 et des espaceurs 11.

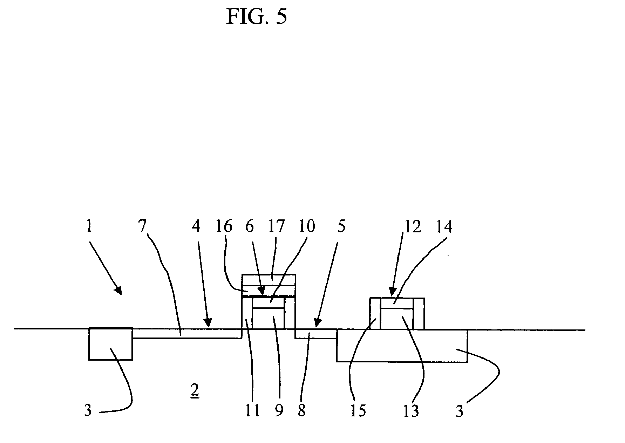

L'on procède ensuite au développement des parties exposées, la résine étant retirée dans les zones ayant subi une exposition simple et dans les zones ayant subi une double exposition. La couche de remplissage 21 est gravée à l'exception de la partie située entre la zone protégée 22 et la grille 6. L'on procède ensuite à la gravure de la couche diélectrique 17, par exemple par gravure sèche s'arrêtant sur la couche diélectrique 16. Le reste de couche de résine présent dans la zone protégée 22 et de couche de remplissage 21 située sous la zone protégée 22 est retiré par exemple par un procédé à l'oxygène. On procède ensuite à la gravure de la couche diélectrique 16, par exemple par voie humide avec de l'acide fluorhydrique dilué en s'arrêtant sur la surface supérieure du substrat 2, des tranchées isolantes 3 et des zones siliciurées 7 et 8 ainsi que de la grille 12 et des espaceurs 15. Lors de la gravure de la couche diélectrique 17, ladite couche diélectrique 17 subsiste au droit de la zone protégée 22, en d'autres termes sensiblement au-dessus de la grille 6 et des espaceurs 11. Lors de la gravure de la couche diélectrique 16, la portion de la couche diélectrique 16 située entre la portion restante de la couche diélectrique 17 d'une part et la grille 6 et les espaceurs 11 d'autre part, est protégée et subsiste (voir figure 5).

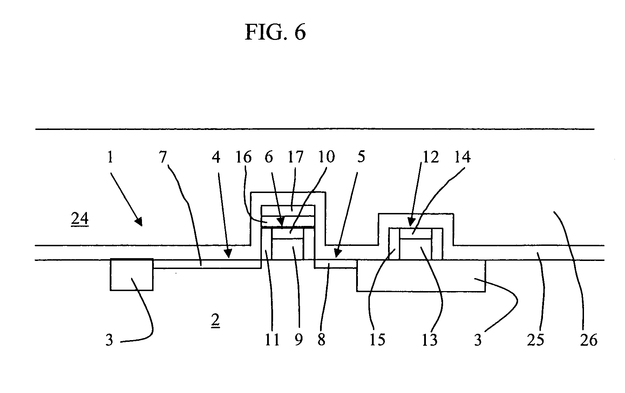

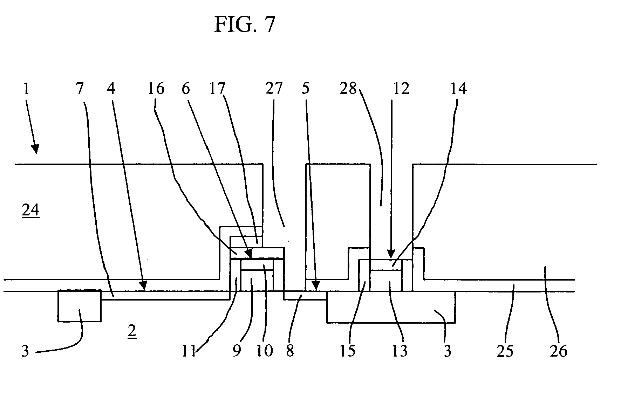

Comme illustré sur la figure 6, on vient ensuite déposer une couche diélectrique épaisse 24 sur l'ensemble du circuit intégré 1. La couche diélectrique épaisse 24 peut comprendre une première sous-couche 25 dite CESL, par exemple à base de nitrure de silicium puis une deuxième sous-couche 26 à base de SiO₂ qui fait ensuite l'objet d'un aplanissement par polissage mécanochimique CMP. La couche diélectrique épaisse 24 fait ensuite l'objet d'une gravure anisotrope pour former des trous 27 et 28 (voir figure 7). Le trou 27 est formé à cheval entre la zone siliciurée 8 et la portion restante de la couche diélectrique 17 au-dessus de la grille 6. Le trou 28 est disposé principalement au-dessus de la partie supérieure 14 siliciurée de la grille 12 et au-dessus d'un espaceur 15. Les trous 27 et 28 sont formés d'abord par gravure de la sous-couche 26 à base de SiO₂ de la couche diélectrique épaisse 24, puis par gravure de la sous-couche 25 d'arrêt à base de nitrure de silicium de la couche diélectrique épaisse 24. Le trou 27 atteint d'une part la zone siliciurée 8 et d'autre part est limité par la couche diélectrique 16 qui présente une excellente sélectivité de gravure par rapport à la couche diélectrique 17. Le trou 28 débouche sur la surface supérieure de la partie supérieure siliciurée 14 de la grille 12.

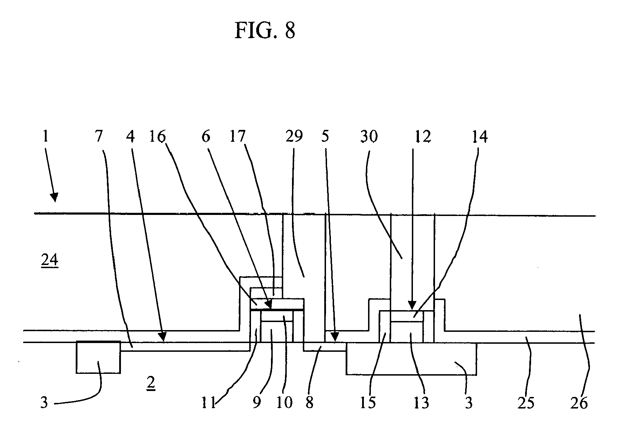

Comme on peut le voir sur la figure 8, on vient ensuite déposer du métal dans les trous 27 et 28, par exemple du tungstène, pour former des plots de connexion 29 et 30 correspondant respectivement aux trous 27 et 28. Le plot 29 est en contact direct avec la zone siliciurée 8 tout en étant isolé de la zone siliciurée 10 de la grille 6 en raison de la présence de la couche diélectrique 16. Le plot d'interconnexion 30 est en contact direct avec la zone siliciurée 14 de la grille 12 d'où un excellent contact électrique.

Grâce à l'invention, on voit qu'en utilisant judicieusement deux masques de gravure utilisés au préalable pour la formation des tranchées d'isolation 3 et des grilles 6 et 12, on parvient à former des plots d'interconnexion 29 destinés à entrer en contact avec des parties supérieures du substrat tout en restant isolés d'une grille 6 voisine disposée au-dessus du substrat 2 et des plots d'interconnexion 30 en contact direct avec une grille 12 située au-dessus d'une tranchée d'isolation 3. En assurant ainsi de façon fiable et économique l'isolation électrique entre un plot d'interconnexion destiné à être relié à une source ou à un drain et une grille, on peut réduire la distance séparant un plot d'interconnexion et une grille, et réduire la distance entre deux grilles disposées au-dessus de zones actives d'un substrat, d'où une densité d'intégration plus élevée, ce qui permet d'envisager de fabriquer des cellules mémoire en occupant une surface de substrat plus faible.

A titre de variante, on peut envisager de remplacer les deux étapes d'exposition illustrées respectivement sur les figures 3 et 4 par une seule étape au cours de laquelle on mettra en oeuvre un masque résultant de la combinaison mathématique des masques utilisés dans les étapes des figures 3 et 4. Ledit masque comporte seulement des zones protégées 22 correspondant à des grilles de transistor, lesdites grilles étant disposées au-dessus de zones actives du substrat 2. Ledit masque peut être généré de façon économique à partir de deux masques existants par combinaison mathématique et ce, sans être soumis au coût et au délai de développement d'un masque entièrement nouveau.

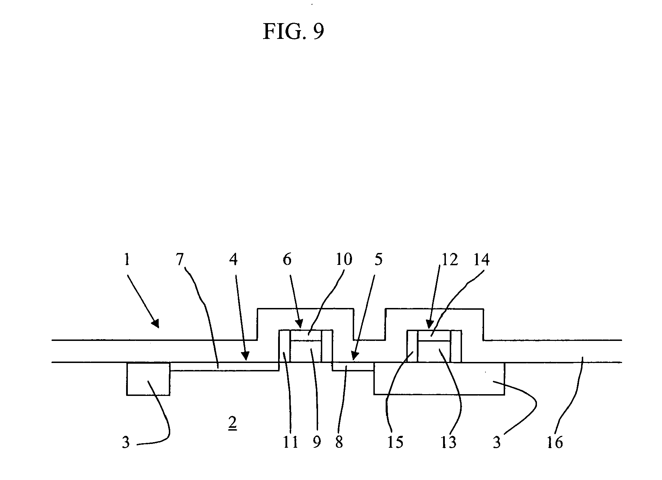

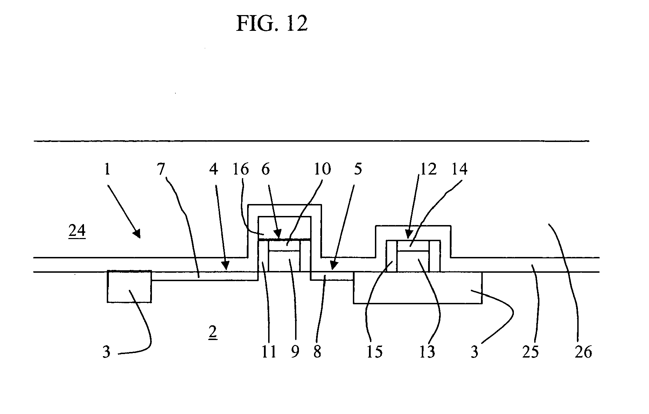

Dans le mode de réalisation illustré sur les figures 9 à 14, les références des éléments semblables ont été conservées. Comme on peut le voir sur la figure 9, une couche diélectrique 16 plus épaisse que dans le mode de réalisation précédent est déposée sur le circuit intégré 1. L'épaisseur de la couche diélectrique 16 peut être comprise entre 50 et 200 angströms, préférablement entre 80 et 150 angströms. La couche diélectrique 16 peut comprendre du dioxyde d'aluminium Al₂O₃. A la différence du mode de réalisation précédent, il n'est pas prévu de couche diélectrique 17 disposée sur la couche diélectrique 16.

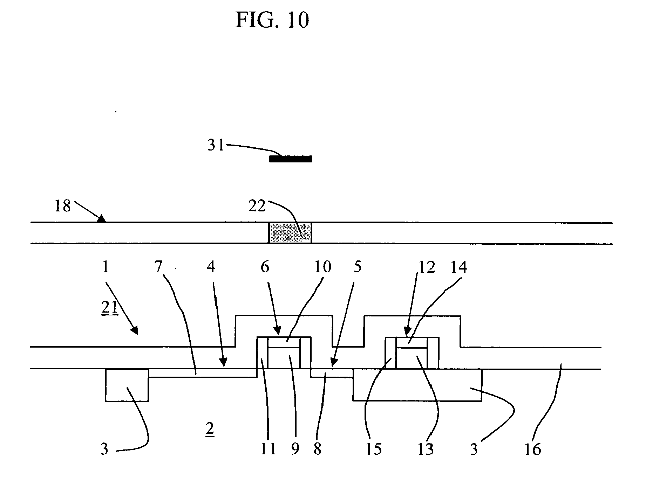

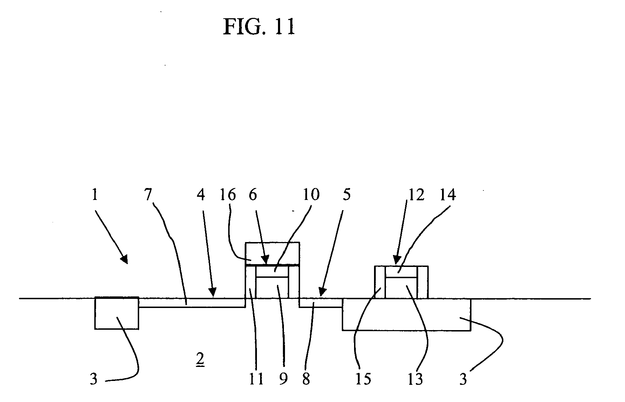

Comme on peut le voir sur la figure 10, une couche de remplissage 21 est déposée suivie d'une couche de résine 18. Au moyen d'un masque 31 résultant de la combinaison mathématique des deux masques utilisés aux modes de réalisation précédents, on effectue une exposition unique de la couche de résine 18, une portion protégée 22 disposée verticalement au-dessus de la grille 6 restant non exposée. On procède ensuite au développement de la résine exposée, ce qui provoque sa disparition sauf dans la zone protégée 22. Puis on effectue une gravure du matériau de remplissage 21 qui peut comprendre du carbone amorphe. La gravure peut s'effectuer à l'oxygène et provoque le retrait du matériau de remplissage 21 en dehors d'une zone comprise entre la zone protégée 22 et la couche diélectrique 16. On procède ensuite à la gravure anisotrope de la couche diélectrique 16, ce qui provoque son retrait sauf dans la zone protégée par la zone protégée 22 et la portion de matériau de remplissage restant entre la zone protégée 22 et la grille. La gravure de la couche diélectrique 16 peut être effectuée par voie humide avec de l'acide fluorhydrique dilué. Ce type de gravure est très sélectif par rapport au silicium du substrat 2, à l'oxyde de silicium des tranchées isolantes 3 et au siliciure métallique des zones siliciurées 7 et 8. Comme on peut le voir sur la figure 11, il subsiste alors un chapeau de matériau diélectrique résultant de la gravure de la couche diélectrique 16 disposée au-dessus de la grille 6 et des espaceurs 11.

On dépose ensuite un ensemble bi-couches 24 comprenant une première couche 25 d'arrêt, par exemple à base de nitrure de silicium et une deuxième couche diélectrique 26, par exemple à base d'oxyde de silicium et présentant une forte épaisseur, ce qui permet d'obtenir une surface supérieure plane à partir de laquelle on peut procéder aisément à des étapes de gravure.

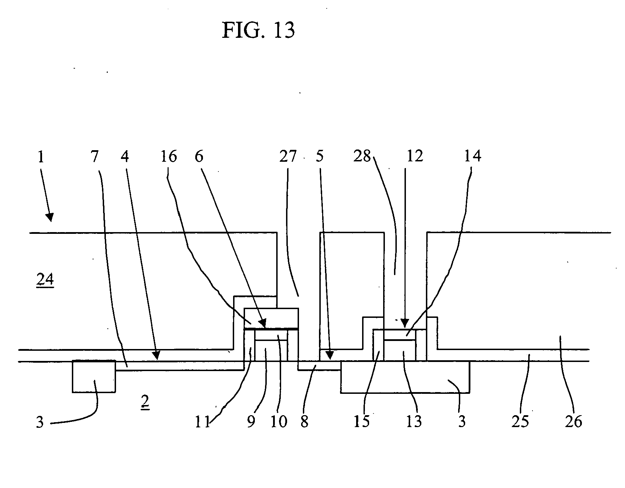

L'on effectue tout d'abord une gravure anisotrope de la couche diélectrique 26 sélectivement par rapport à la couche d'arrêt 25, puis une gravure anisotrope de la couche d'arrêt 25 sélective par rapport à la couche diélectrique 16 et par rapport à la partie supérieure 14 siliciurée de la grille 12 et par rapport à la zone siliciurée 8 (voir figure 13). On procède ensuite au remplissage des trous 27 et 28 ainsi formés à travers l'ensemble bi-couche 24 par une espèce métallique, par exemple du tungstène, pour former des connecteurs.

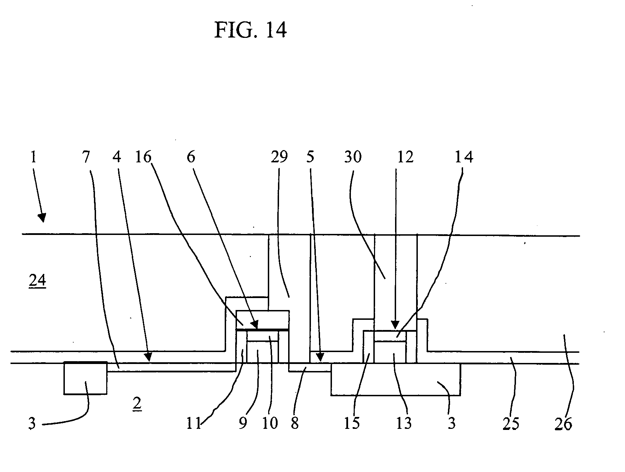

Comme on peut le voir sur la figure 14, les connecteurs 29 et 30 formés dans les trous 27 et 28 de la figure 13 remplissent lesdits trous. Le connecteur 29 est isolé par rapport à la partie supérieure siliciurée 10 de la grille 6 grâce au chapeau formé par la couche diélectrique 16 tout en étant en contact électrique avec la zone siliciurée 8. Le connecteur 30 est en contact direct avec la partie supérieure siliciurée 14 de la grille 12.

A titre de variante, on peut prévoir de réaliser le premier mode de réalisation avec un seul masque résultant de la combinaison mathématique du masque servant à la définition des tranchées d'isolation et du masque servant à la définition des grilles ou encore d'exécuter le deuxième mode de réalisation en mettant en oeuvre lesdits deux masques successivement.

Le procédé se prête extrêmement bien à une fabrication économique de circuits intégrés, notamment de cellules mémoire à très haute densité en réduisant très fortement le risque de court-circuit entre le contact et une grille disposée sur une zone active. De par sa conception, le procédé assure qu'une grille disposée au-dessus d'une tranchée d'isolation peut être reliée à un plot de contact, ce qui s'avère souhaitable dans la mesure où l'encombrement du circuit intégré est nettement plus faible au-dessus des tranchées d'isolation, et assure également qu'une grille disposée au-dessus d'une zone active est isolée par rapport aux plots de connexion, ce qui permet d'utiliser de façon fiable des plots pour la connexion avec un drain ou une source de transistor dans une zone où l'encombrement du circuit intégré est en général très élevé. Bien entendu, la grille 6 illustrée sur les figures peut s'étendre transversalement au plan de coupe jusqu'à venir au-dessus d'une tranchée d'isolation et être reliée en ce lieu à un plot de connexion permettant de commander le ou les transistors correspondants.

Le procédé de fabrication d'un circuit intégré permet de réaliser une grille isolée d'un plot d'interconnexion formé à proximité et relié à une surface supérieure de substrat au-dessus d'une zone active. A cette fin, une couche diélectrique est formée au-dessus de la partie supérieure de la grille et éventuellement au-dessus de l'espaceur voisin de la grille. La couche diélectrique est formée sur l'ensemble du circuit intégré puis gravée en utilisant les masques utilisés au préalable pour la fabrication de la grille et pour la fabrication de la zone isolante.

Le circuit intégré peut comprendre un substrat dans lequel est formée au moins une zone active et au moins une zone isolante, par exemple une tranchée d'isolation peu profonde. Une grille est formée au-dessus d'une zone active du substrat. Une couche diélectrique comprenant de l'oxyde d'aluminium est disposée au-dessus de la partie supérieure de la grille tout en étant dans la mesure du possible, légèrement plus large. Ainsi, la grille est isolée électriquement par rapport à d'autres éléments formés au voisinage de la couche diélectrique, notamment d'un plot de connexion relié à la zone active mais susceptible de chevaucher partiellement la grille compte tenu des imprécisions de fabrication.

## Revendications

1. Procédé de protection de la grille (6) d'un transistor dans un circuit intégré (1) pour la réalisation d'un plot d'interconnexion (29), le transistor comprenant un substrat (2), au moins une zone active formée dans le substrat, au moins une zone isolante (3) formée dans le substrat, une grille (6), la grille étant formée au-dessus d'une zone active, le procédé comprenant les étapes suivantes :
- former une couche diélectrique (16) sur le transistor, la couche diélectrique venant recouvrir la grille ;
- effectuer une gravure de la couche diélectrique (16) en la laissant subsister au moins sur ladite grille de telle sorte que ladite grille est isolée électriquement par rapport à d'autres éléments formés au-dessus de ladite couche diélectrique, ladite gravure étant effectuée au moyen d'un masque utilisé pour la fabrication de la grille et au moyen d'un masque utilisé pour la fabrication de la zone isolante.

2. Procédé selon la revendication 1, dans lequel le masque utilisé pour la fabrication de la grille et le masque utilisé pour la fabrication de la zone isolante sont combinés préalablement à la gravure.

3. Procédé selon la revendication 1, dans lequel le masque utilisé pour la fabrication de la grille et le masque utilisé pour la fabrication de la zone isolante sont mis en oeuvre successivement.

4. Procédé selon l'une quelconque des revendications précédentes, dans lequel la couche diélectrique comprend une sous-couche (16) à base d'oxyde d'aluminium et une sous-couche (17) à base de nitrure de silicium.

5. Procédé selon l'une quelconque des revendications 1 à 3, dans lequel la couche diélectrique comprend une couche à base d'oxyde d'aluminium.

6. Procédé selon l'une quelconque des revendications précédentes, dans lequel un plot d'interconnexion (29) est formé au-dessus d'une zone active et partiellement au dessus de la grille.

7. Procédé selon l'une quelconque des revendications précédentes, dans lequel l'étape a) comprend le dépôt conforme d'au moins une couche pouvant être gravée sélectivement par rapport au substrat.

8. Procédé selon l'une quelconque des revendications précédentes, dans lequel l'étape b) comprend :
b1) le dépôt d'une couche de résine (18),
b2) l'exposition de la couche de résine hors de ladite grille,
b3) le développement des parties exposées de la couche de résine,
b4) le retrait de la partie découverte de la couche diélectrique,
b5) le retrait du reste de la couche de résine.

9. Procédé selon la revendication 8, dans lequel avant l'étape b1) a lieu le dépôt d'une couche de remplissage (21), entre les étapes b3) et b4) a lieu le retrait de la partie découverte de la couche de remplissage (21).

10. Circuit intégré (1) comprenant un transistor formé dans un substrat pourvu d'au moins une zone isolante (3), le transistor comprenant au moins une zone active formée dans le substrat, une grille (6), la grille étant formée au-dessus d'une zone active, **caractérisé par le fait qu'**il comprend une couche diélectrique (16) comprenant de l'oxyde d'aluminium, recouvrant au moins la grille, de telle sorte que ladite grille (6) est isolée électriquement par rapport à d'autres éléments formés au-dessus de ladite couche diélectrique.

11. Circuit selon la revendication 10, dans lequel la couche diélectrique (16) comprend une épaisseur à base d'oxyde d'aluminium comprise entre 3 et 15 nm.

12. Circuit selon la revendication 11, dans lequel la couche diélectrique comprend, en outre, une épaisseur à base de nitrure de silicium comprise entre 5 et 15 nm.
